**Europäisches Patentamt**

**European Patent Office**

**Office européen des brevets**

(19)

(11) Veröffentlichungsnummer: **0 087 051**

**A2**

(12)

# EUROPÄISCHE PATENTANMELDUNG

(21) Anmeldenummer: **83101147.3**

(22) Anmeldetag: **07.02.83**

(51) Int. Cl.³: **H 05 K 1/02**

(30) Priorität: 17.02.82 DE 3205591

(43) Veröffentlichungstag der Anmeldung:
31.08.83 Patentblatt 83/35

(84) Benannte Vertragsstaaten:
BE FR IT NL

(71) Anmelder: SIEMENS AKTIENGESELLSCHAFT
Berlin und München Wittelsbacherplatz 2
D-8000 München 2(DE)

(72) Erfinder: Schmidt, Hans-Friedrich, Dr.Ing.
Graf-Tattenbach-Weg 3
D-8196 Eurasburg(DE)

(72) Erfinder: v.Tomkewitsch, Sybille
Hochfeld 14
D-8134 Pöcking(DE)

(54) **Basismaterial für flexible gedruckte Schaltungen.**

(57) Als Trägermaterial für hochtemperaturbeständige, flexible Basismaterialien für gedruckte Schaltungen werden hochtemperaturbeständige Thermoplaste, z. B. Polyetheretherketon (PEEK) verwendet, die ohne Hilfsstoffe mit der Metallfolie zu einem Duplex- oder Multiplexverbund verpreßt werden.

EP 0 087 051 A2

SIEMENS AKTIENGESELLSCHAFT
Berlin und München

Unser Zeichen
VPA 82 P 1096 E

Basismaterial für flexible gedruckte Schaltungen.

Die Erfindung bezieht sich auf ein hochtemperaturbeständiges, flexibles Basismaterial für gedruckte Schaltungen mit einem Trägermaterial aus einem Isolierstoff, auf dem eine Schicht aus elektrisch gut leitendem Material fest haftend aufgebracht ist.

Derartige Materialien werden für die Herstellung gedruckter Schaltungen nach den üblichen Verfahren benötigt. Eine wichtige Forderung dabei ist die feste Haftung der leitenden Schicht, z. B. einer Kupferfolie, auf dem Träger, damit die Leiterbahnen der herzustellenden gedruckten Schaltung auch nach dem Entfernen des zunächst zwischen den späteren Leiterbahnen liegenden leitenden Materials fest und unverrückbar auf dem Träger verbleiben.

Die Trägerfolie, z. B. Polyimid (Kapton), wird z. B. bei der Herstellung des Basismaterials unter Einsatz eines Kleberfilmes mit der Metallfolie zu flexiblem Basismaterial verklebt. Die Schwachstelle dieses Verbundes ist der Kleberfilm, der insbesondere bei Duplex- und Multiplexmaterialien zu Schwierigkeiten bezüglich Schälfestigkeit und Temperaturbeständigkeit führt.

Der Erfindung liegt die Aufgabe zugrunde, ein Basismaterial der eingangs definierten Form anzugeben, das ohne Haftvermittler eine feste Haftung zwischen dem Träger und der leitenden Schicht garantiert und auch bei Duplex- und Multiplexmaterialien zu keinen Schwierigkeiten bezüglich Schälfestigkeit und Temperaturbeständigkeit führt.

Wed 1 Plr/17.2.1982

Diese Aufgabe wird dadurch gelöst, daß als Trägermaterial eine Folie aus bestimmten hochtemperaturbeständigen Thermoplasten, die eine gute Adhäsion gegenüber Metallfolien besitzen, z. B. Polyetheretherketon (PEEK), verwendet wird, auf die Metallfolie direkt ohne Hilfsstoffe zu einem Duplex- oder Multiplex-Verbund aufgepreßt wird. Der wesentliche Vorteil der Erfindung liegt darin begründet, daß bei der Verwendung einer Folie aus hochtemperaturbeständigen Thermoplasten als Trägermaterial auf den Einsatz einer Kleberfolie vollkommen verzichtet werden kann.

Neben einer Kosteneinsparung bei der Herstellung von flexiblen Basismaterial für gedruckte Schaltungen ergeben sich z. B. gegenüber Polyimid-Basismaterialien folgende Vorteile:

1. Wasseraufnahme ca. 1/10 von Polyimid,
2. erhöhte Schälfestigkeit,
   z. B. Verbund: Galvanik-Cu/Trägerfolie,
3. bessere Wärmebeständigkeit,
   z. B. Verbund: Galvanik-Cu/Trägerfolie,
4. keine Metallfolienablösung in Entschichtungsstraßen,
5. Polyetheretherketon kann im Gegensatz zu Polyimid extrudiert werden und
6. eine vereinfachte Mehrlagentechnik.

Das Verfahren zur Herstellung von Basismaterial nach der Erfindung besteht darin, daß die hochtemperaturbeständige Thermoplastfolie, z. B. PEEK, oberhalb ihrer Schmelztemperatur mit der Metallfolie verpreßt, anschließend die Temperatur unter Beibehaltung des Druckes auf einen Wert zwischen Schmelz- und Rekristallisationstemperatur der Folie gebracht und bis zum Erreichen der maximalen Kristallinität der Folie belassen wird. Die Schmelztemperatur einer PEEK-Folie liegt z. B. bei 334°C und die Rekristallisationstemperatur bei 185°C.

Der wesentliche Vorteil, der mit dem Erreichen der maximalen Kristallinität zu erzielen ist, besteht darin, daß verhindert wird, daß die hochtemperaturbeständige Thermoplastfolie bei erneuter Temperaturbelastung nachkristallisiert, was zu einem Schrumpfen des Materials führen würde, sowie die Verbesserung der Chemikalienbeständigkeit, z. B. gegenüber Dichlormethan. Dichlormethan wird zum Ablösen des Photoresists nach dem Ätzvorgang verwendet, so daß das für Kaptonfolien entwickelte Bearbeitungsverfahren verwendet werden kann.


2 Patentansprüche

Patentansprüche.

1. Hochtemperaturbeständiges, flexibles Basismaterial für gedruckte Schaltungen mit einem Trägermaterial aus einem Isolierstoff, auf dem eine Schicht aus elektrisch gut leitendem Material fest haftend aufgebracht ist, d a d u r c h g e k e n n z e i c h n e t , daß als Trägermaterial eine Folie aus bestimmten hochtemperaturbeständigen Thermoplasten, die eine gute Adhäsion gegenüber Metallfolien besitzen, z. B. Polyetheretherketon (PEEK), verwendet wird, auf die die Metallfolie direkt ohne Hilfsstoffe zu einem Duplex- oder Multiplex-Verbund aufgepreßt wird.

2. Verfahren zur Herstellung von Basismaterial nach Anspruch 1, d a d u r c h g e k e n n z e i c h n e t , daß die hochtemperaturbeständige Thermoplastfolie, z. B. PEEK-Folie, oberhalb ihrer Schmelztemperatur mit der Metallfolie verpreßt, anschließend die Temperatur unter Beibehaltung des Druckes auf einen Wert zwischen Schmelz- und Rekristallisationstemperatur der Folie gebracht und bis zum Erreichen der maximalen Kristallinität der Folie belassen wird.